Europäisches Patentamt

European Patent Office

Office européen des brevets

(11) Veröffentlichungsnummer: **0 248 425 B1**

(19)

(12) # EUROPÄISCHE PATENTSCHRIFT

(45) Veröffentlichungstag der Patentschrift: **07.08.91**

(51) Int. Cl.⁵: **H03F 3/24, H03F 1/34**

(21) Anmeldenummer: **87108074.3**

(22) Anmeldetag: **04.06.87**

(54) **Senderanordnung mit einer transistorisierten Gegentakt-Endstufe.**

(30) Priorität: 06.06.86 DE 3619110
30.10.86 DE 3636865
29.11.86 DE 3640969

(43) Veröffentlichungstag der Anmeldung:
**09.12.87 Patentblatt 87/50**

(45) Bekanntmachung des Hinweises auf die
Patenterteilung:
**07.08.91 Patentblatt 91/32**

(84) Benannte Vertragsstaaten:
**DE FR GB IT**

(56) Entgegenhaltungen:
**EP-A- 0 135 154      DE-A- 2 015 812
US-A- 4 370 622      US-A- 4 392 245
US-A- 4 412 337      US-A- 4 591 800**

**ELEKTRONIK, Band 30, Nr. 11, Seiten 51,52,
München, DE; W. WEIDMANN:
"GaAs-FET-Leistungsverstärker im X-und KU-
Band"**

(73) Patentinhaber: **TELEFUNKEN SYSTEMTECHNIK
GMBH
Sedanstrasse 10
W-7900 Ulm (Donau)(DE)**

(72) Erfinder: **Esprester, Ralf, Dr.
Haydnweg 2
W-7909 Dornstadt(DE)**
Erfinder: **Mähr, Harry
Fuggerweg 7
W-7958 Untersulmetingen(DE)**
Erfinder: **Schuster, Harald, Dipl.-Ing.
Fellhornweg 31
W-7901 Neu-Ulm(DE)**
Erfinder: **Sigloch, Ferdinand, Dipl.-Ing.
Blaubergstrasse 11
W-7902 Blaubeuren(DE)**
Erfinder: **Krüger, Udo
Wullenstetter Strasse 4
W-7913 Senden 3(DE)**
Erfinder: **Humann, Klaus, Dipl.-Ing.
Grüntenstrasse 5
W-7913 Senden(DE)**

(74) Vertreter: **Schulze, Harald Rudolf, Dipl.-Ing. et
al
TELEFUNKEN SYSTEMTECHNIK GMBH Sedanstrasse 10
W-7900 Ulm(DE)**

EP 0 248 425 B1

## Beschreibung

Moderne kommerzielle Kurzwellen-Sender, etwa der Leistungsklasse bis 1 kW Nennleitung, sind heute voll transistorisiert. In den Endstufen sind häufig Gegentakt-Leistungstransistoren über Breitband-Brücken (Parallelschaltbrücken) parallel betrieben (Breitband-Verstärkertechniken von 1,5 bis 30 MHz - ohne Umschaltung, - ohne Abstimmittel).

Die Breitbandigkeit ist gegenüber den älteren (schmalbandigen, abgestimmten) Röhrensendern ein wesentlicher Fortschritt. Die Umschaltzeiten bei Frequenzwechsel sind lediglich durch Oberwellenfilter bedingt, welche z. B. mit Vakuum-Relais digital geschaltet werden.

Nachteilig an Transistor-Sendern ist allerdings deren gegenüber Röhrensendern ungünstigeres Verhalten bezüglich der Intermodulationstonbildung. Während die Intermodulationprodukte gerader Ordnung durch die Symmetrie der Gegenakt-Anordnung bereits weitgehend unterdrückt sind, können die ungeradzahligen IM-Produkte z. B. durch Betrieb des Verstärkers in einem günstigen Kennlinienbereich wie beispielsweise A- oder AB-Betrieb und Stabilisierung der Stromversorgung abgesenkt werden. Für Senderanordnungen, bei welcher Platzbedarf und Gewicht und damit indirekt auch der Kostenaufwand eine bedeutende Rolle spielen, wie beispielsweise bei mobilen Sendern, ist dies aber vor allem dadurch nachteilig, daß durch den geringeren Wirkungsgrad elektrische Versorgungseinrichtungen mit höherer verfügbarer Leistung, aufwendige Kühleinrichtungen zur Abführung der Verlustwärme und zusätzlich die Stabilisierungseinrichtung den Peripherieaufwand deutlich erhöhen.

Aus der DE-A-2 015 812 ist ein Hochfrequenz-Leistungsverstärker bekannt, bei welchem im Zuge des Hochfrequenzsignals vor der Senderendstufe ein steuerbarer Phasenschieber und ein steuerbares Dämpfungsglied angeordnet sind. Diese werden angesteuert über Differenzglieder, an deren Eingängen Signale liegen, die aus Hüllkurvendetektoren stammen.

Der Erfindung liegt die Aufgabe zugrunde, eine Senderanordnung mit einer transistorisierten Gegentakt-Endstufe anzugeben, die bei guten Intermodulationseingenschaften mit geringem Peripherieaufwand auskommt und dadurch insbesondere auch für mobile Sender von Vorteil ist.

Die Erfindung ist in den Patentansprüchen 1 und 2 beschrieben. Der Unteranspruch enthält vorteilhafte Ausgestaltung der Erfindung.

Die Erfindung macht sich dabei Erkenntnisse aus dem bei Röhrensendern gebräuchlichen Einhüllenden-Gegenkopplungsprinzip (z. B. TELEFUNKEN-ZEITUNG, Dez. 1962 Heft 138, Seite 314 bis 323) zunutze.

Ein besonderer Vorteil der Erfindung ist darin zu sehen, daß an die Leistungsverstärkerstufe, die bei herkömmlichen transistorisierten Senderendstufen sehr aufwendig ist, nur noch geringe Anforderungen gestellt werden, was sich günstig auf deren Preis, Gewicht und Platzbedarf, indirekt aber auch auf Einsparungen beispielsweise bei der Spannungsversorgung der Endstufe auswirkt. Insbesondere kann die Gegentakt-Endstufe mit hohem Wirkungsgrad, vorzugsweise als Klasse B-Verstärker, betrieben und aus einer ungeregelten Gleichspannungsquelle, beispielsweise dem Bordnetz eines Fahrzeugs, versorgt werden. Bei der Bereitstellung des Referenzsignals kann bereits auch eine u. U. gegebene Frequenzabhängigkeit des Signalpegels durch verschiedene Bauelemente im Signalweg ausgeglichen und damit auf einfache Weise die Ausgangsleistung des Senders stabilisiert werden, was insbesondere für Frequenzsprung-Sender mit häufigem Frequenzwechsel von Bedeutung ist.

Die Erfindung ist nachfolgend unter Bezugnahme auf die Abbildungen anhand von Ausführungsbeispielen noch erläutert. Dabei zeigt:

FIG. 1    die typische Verstärkungskennlinie einer RF-Transistor-Endstufe
FIG. 2    das Prinzip der Anordnung
FIG. 3    einen Vergleich der Signaleinhüllenden von Quellensignal und Sendesignal
FIG. 4    Spektren eines Zweiton-Sendesignals
FIG. 5, 6    Ausführungsformen
FIG. 7    eine Ausführungsform der Erfindung
FIG. 8    eine bevorzugte Ausführungsform

Die breitbandige Senderverstärker-Endstufe verzerre nur in der Amplitude, nicht in der Phase. Diese Forderung wird von verfügbaren Leistungstransistoren im HF-Bereich ausreichend erfüllt. Außerdem sei nur ein schmaler spektraler Bereich betrachtet, d. h. die Bandbreite der Verstärker-Endstufe sei wesentlich größer als die für ein bestimmtes Sendesignal erforderliche Bandbreite. Unterschiede der Phasenbeeinflussung durch die Transistoren sind in dem schmalen Bereich dann vernachlässigbar.

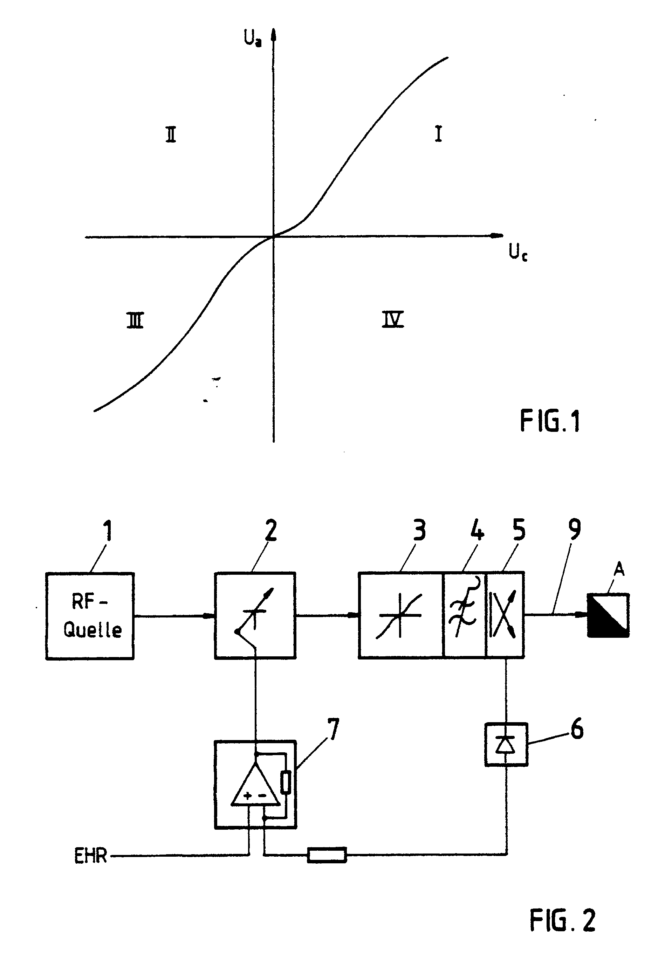

Die Verstärkungskennlinie einer Klasse B-Gegentakt-Endstufe kann wie in FIG. 1 dargestellt werden ($U_c$ Eingangsspannung, $U_a$ Ausgangsspannung). Wesentlich ist, daß die Kennlinienverläufe im ersten und dritten Quadranten gut übereinstimmen, was mit ausgesuchten Transistorpaaren (Gegentakt-Stufen) aber leicht zu

EP 0 248 425 B1

erreichen ist. Unter diesen Annahmen wird erfindungsgemäß ein in FIG. 2 skizzierter Regelkreis aufgebaut.

Die RF-Quelle 1 liefert ein Signal, das beispielsweise aus einem Mehrtongemisch (z. B. zwei Töne gleicher Amplitude) bestehe. Zwischen der Quelle 1 und der Senderendstufe 3 ist ein schnell reagierendes steuerbares Dämpfungsglied 2 eingeschaltet. Dieses Dämpfungsglied wird von einem ausreichend breitbandigen Operationsverstärker 7 angesteuert.

Das Ausgangssignal des Gegentakt-Leistungsverstärkers 3 wird über das Oberwellenfilter 4 und die Richtkoppler-Anordnung 5 als moduliertes RF Leistungssignal 9 der als Last angeschlossenen Antenne A zugeführt. Im Richtkoppler wird ein geringer Signalanteil für den Hüllkurven-Detektor 6 ausgekoppelt. Der Detektor 6 liefert ein Einhüllenden-Signal des RF-Ausgangssignals 9 für den einen Eingang des Differenzverstärkers 7. An dessen anderem Eingang liegt ein Einhüllenden-Referenzsignal EHR an, das im signalaufbereitenden Teil des Senders, also bei kleinen Signalpegeln, erzeugt wird und dem Soll-Zeitverlauf der Signal-Einhüllenden des RF-Ausgangssignals proportional ist. Aus dem Vergleich des Referenzsignals EHR und des Einhüllenden-Signals vom Detektor 6 erzeugt der Operationsverstärker 7 ein Steuersignal für das Dämpfungsglied 2.

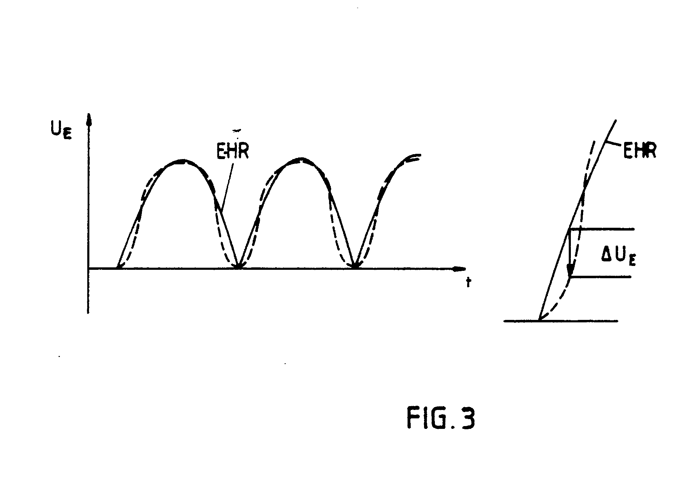

Durch die nichtlineare Kennlinie des Endverstärkers 3 wird das Ausgangssignal 9 und damit auch der vom Richtkoppler ausgekoppelte Signalanteil gegenüber dem unverzerrten Signal Abweichungen zeigen. In FIG. 3 ist das Referenzsignal EHR, das der Einhüllenden des unverzerrten RF-Signals entspricht, und das Einhüllenden-Signal EHS des Sendesignal $U_s$ gezeigt. Es handelt sich dabei am Ausgang der RF-Quelle 1 um ein sinuston-moduliertes Signal mit entsprechenden Sinus-Halbwellen (durchgezogene Linien) als Einhüllende. Durch Nichtlinearitäten der Endstufe ergibt sich ein Ausgangssignal mit abweichender Einhüllungsform. Diese Abweichungen $\Delta U_E$ (vergrößert dargestellter Ausschnitt) führen als Differenzsignal verstärkt das Dämpfungsglied 2 so nach, daß die Ansteuerung der Endstufe 3 bei kleinen Signalpegeln um den Differenzbetrag angehoben, bei den mittleren Pegeln nicht korrigiert wird, dagegen mit zunehmender Ansteuerung die Dämpfung erhöht, im Sättigungsbereich wieder reduziert wird.

Dies erfordert, daß die Dämpfung des Dämpfungsglieds trägheitslos folgen kann, und daß die Bandbreite des Operationsverstärkers und dessen Phasengang dafür geeignet sind. Schaltungstechnische Maßnahmen hierfür sind allgemein bekannt.

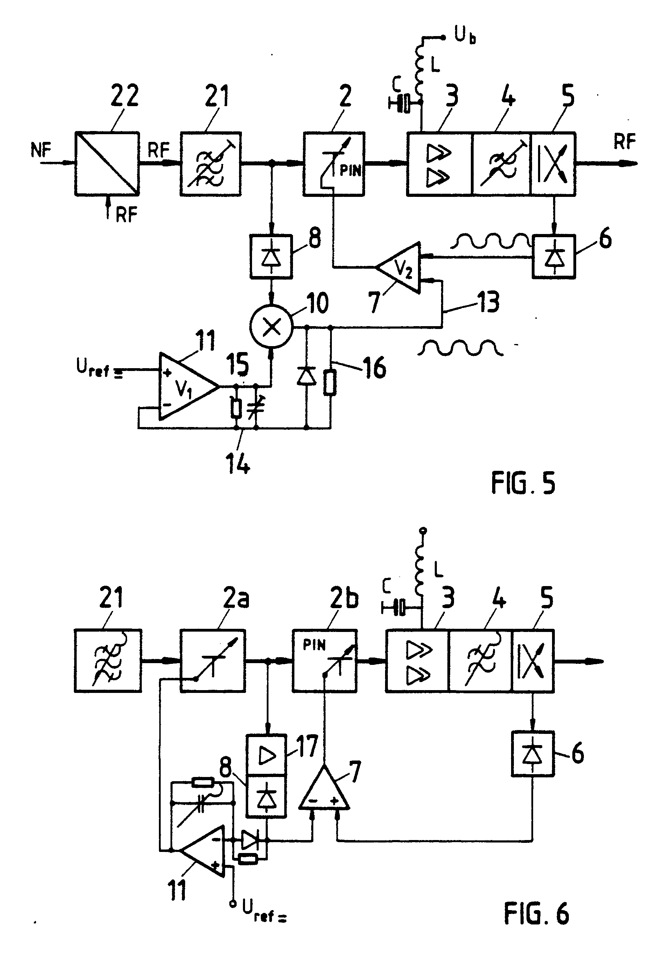

In der Praxis ist die Quelle 1 der eigentliche Sende-Umsetzer-Ausgang, dessen RF-Signal als intermodulationsarm vorausgesetzt werden kann. Die Spitzenamplitude der Einhüllenden ist soweit ausgeregelt, daß diese bereits als Maß für die Einstellung des Ausgangssignals 9 auf Sender-Nennleistung mit Hilfe des Richtkoppler-Signals 5 dienen kann, indem z. B. das Referenzsignal mit Hilfe eines weiteren Einhüllenden-Detektors (8 in FIG. 5 bis 7) aus diesem Quellensignal gewonnen wird.

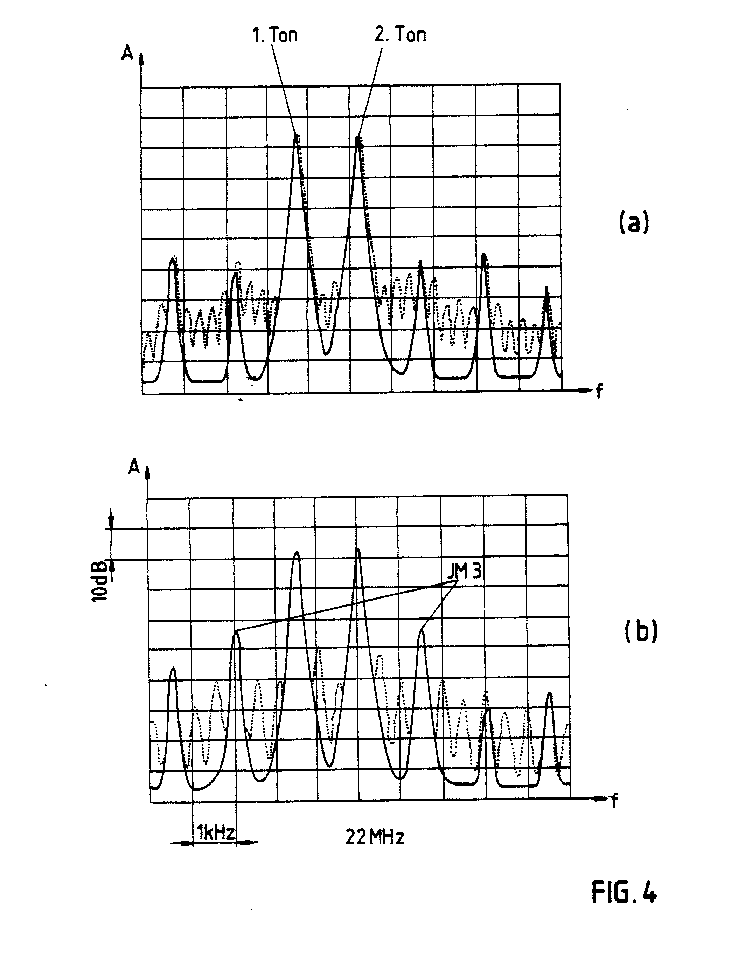

Die FIG. 4 zeigt Spektren des Sendesignals mit (a) und ohne (b) die erfindungsgemäße Anordnung an einer 100-Watt-Senderendstufe für 24V Betriebsspannung, gemessen bei einer tatsächlichen Betriebsspannung von nur 20V =.

Das Quellensignal ist ein Doppelton mit gleicher Amplitude und 1,5 kHz Frequenzabstand. Die Spektralanalyse des Ausgangssignals ohne die Erfindung liefert eine Dämpfung der IM3-Frequenzen (4,5 kHz entsprechend 3 x 1,5 kHz Abstand, das Dreifache der eigentliche Nutztöne) von ca. 26 dB gegen den jeweiligen Nutzton, also 32 dB gegen PEP (Peak Envelope Power, Nennleistung).

Nach Einführung der erfindungsgemäßen Gegenkopplungsmaßnahme erreicht die IM3-Dämpfung > 46dB PEP. Die Dämpfung der IM5-Produkte (Abstand 5 x 1,5 kHz = 7,5 kHz) bleibt annähernd unverändert, da die Bandbreite des eingesetzten Regelkreises diese nicht mehr erfaßt. Durch Regelkreise größerer Bandbreite können auch weiter abliegende Intermodulationsprodukte noch gedämpft werden.

Die punktierten Kurven in den Spektren der FIG. 4 beziehen sich auf ein Störsignal, das aus der Überlagerung einer 20V-Betriebsspannung mit einer Rechteckspannung von $7V_{ss}$ und 500 Hz resultiert.

Während in FIG. 4(b) (ohne Gegenkopplung) der Abstand der Störfrequenzen (punktierter Kurvenverlauf) minimal 30 dB gegen die Amplituden der Nutztöne ist, ist er in FIG. 4(a) dank der Gegenkopplungsmaßnahme etwa 40 dB. Zufolge der im Beispiel endlichen Bandbreite des Gegenkopplungs-Regelkreises ist auch hier eine Wirkung über einen Abstand von ca. 6 kHz hinaus nicht möglich.

Die Anwendung der Erfindung erstreckt sich insbesondere auf alle Senderendstufen, welche z.B. A-Modulation sowie J3E-, J7B-Verfahren zu übertragen haben, also jene Modulationsarten, deren Signaleinhüllende im RF-Bereich variiert bzw. deren Nachrichten-Informations-Gehalt nicht ausschließlich in der Momentan-Phase des Nutzsignals enthalten ist.

Ein praktisches Ausführungsbeispiel zeigt FIG. 5 als Blockschaltbild.

Der Aufbau umfaßt eine Gegentakt-Breitband-Endstufe 3 mit Oberwellenfilter 4 und Richtkoppler 5, Einhüllenden-Gleichrichter 6 am Sender-Ausgang und entsprechendem Einhüllenden-Detektor 8 am Ausgang der Sender-Vorstufen. Das Bandpaß-Filter 21 ist zur Unterdrückung von Oberwellen und unerwünschten Rauschseitenbändern dem Sendeumsetzer nachgeschaltet. Mit dieser Maßnahme ist gewährleistet, daß die Einhüllende des Vorstufen-RF-Signals eine geeignete Referenz 8 des ebenfalls von Oberwellen gefilterten RF-Ausgangssignals der Endstufe an 6 ist.

Als Referenz für die Gegenkopplung dient das Einhüllende-Signal 13, das über den analogen Multiplizierer 10 (Ein-Quadranten-Multiplizierer) bezüglich der Spitzen auf den der Nennleistung des Senders (PEP) entsprechenden Referenzwert $V_{Ref=}$ gestellt ist. Der Operationsverstärker 11 erzeugt dazu den erforderlichen (Gleichspannungs-)Gewichtsfaktor 15. Die Zeitkonstante für diesen Gewichtsfaktor ist bestimmt durch die RC-Glieder 14 und den Spitzenwert-Gleichrichter 16 am Operationsverstärker 11. Letzter bewirkt eine schnelle Korrektur der Referenz 13, sobald der Einhüllenden-Spitzenwert zu hohe Ausgangsleistung erzeugt (kleine Zeitkonstante). Um den verschiedenen Betriebsarten Rechnung tragen zu können, ist der Kondensator 14 umschaltbar. Damit ergeben sich optimierte Regelgeschwindigkeiten.

Die zuvor beschriebene Schaltung hat den Nachteil, daß der Gleichrichter 8 einen kleineren Pegel als der am Richtkoppler 5 angeschlossene Detektor 6 erhält. Die reale Kennlinie eines Gleichrichters kann in solch einem Fall zusätzliche Fehler erzeugen.

Da es sich um ein Differenzverfahren handelt, ist es daher erforderlich, die beiden Detektoren 6 und 8 möglichst auf gleichen RF-Pegel zu setzen. Dies berücksichtigt die Schaltungsanordnung nach FIG. 6.

- Die beiden Detektordioden sind ausgesucht bezüglich der Übereinstimmung ihrer Gleichrichter-Kennlinie (matched diodes).
- Um den Pegel an beiden Dioden möglichst gleich zu erhalten, wird ein breitbandiger klirrarmer RF-Verstärker 17 für die Gleichrichterdiode 8 eingefügt.
- Vor diesen Breitband-RF-Verstärker ist ein weiterer PIN-Dioden-Abschwächer 2a eingefügt, der den Pegel am Gleichrichter 8 konstant stellt. Diese Pin-Dioden-Stellglieder sind ebenfalls breitbandig, hochlinear und passiv (resistiv).

Im Gegensatz zum Dämpfungsglied 2b braucht das erste Dämpfungsglied 2a nicht annähernd so schnell steuerbar sein.

Wie bereits im Zusammenhang mit der FIG. 4 erwähnt, ist die erfindungsgemäße Anordnung unanfällig gegen Störungen der Betriebsspannung $U_b$. Bordspannungsnetze von Fahrzeugen sind erfahrungsgemäß mit starken Störspannungen verseucht, so daß herkömmliche Senderendstufen über einen zwischengeschalteten DC-Schaltwandler versorgt werden. Demgegenüber kann bei der Erfindung die Versorgung direkt aus dem Bordnetz eines Fahrzeugs erfolgen, wenn, wie in FIG. 5 und 6 durch die Glieder L und C angedeutet, durch eine Tiefpaßfilterung die höherfrequenten Störfrequenzanteile ausgesiebt werden, die von dem Gegenkopplungskreis der Erfindung wegen dessen begrenzter Bandbreite nicht ausgeregelt werden können. Da dadurch der DC-Wandler entfallen kann, wird der Wirkungsgrad des Senderverstärkers zusätzlich höher, der Kühlmechanismus einfacher und somit auch die Gesamtkosten des Senders günstiger als in herkömmlichen Geräten.

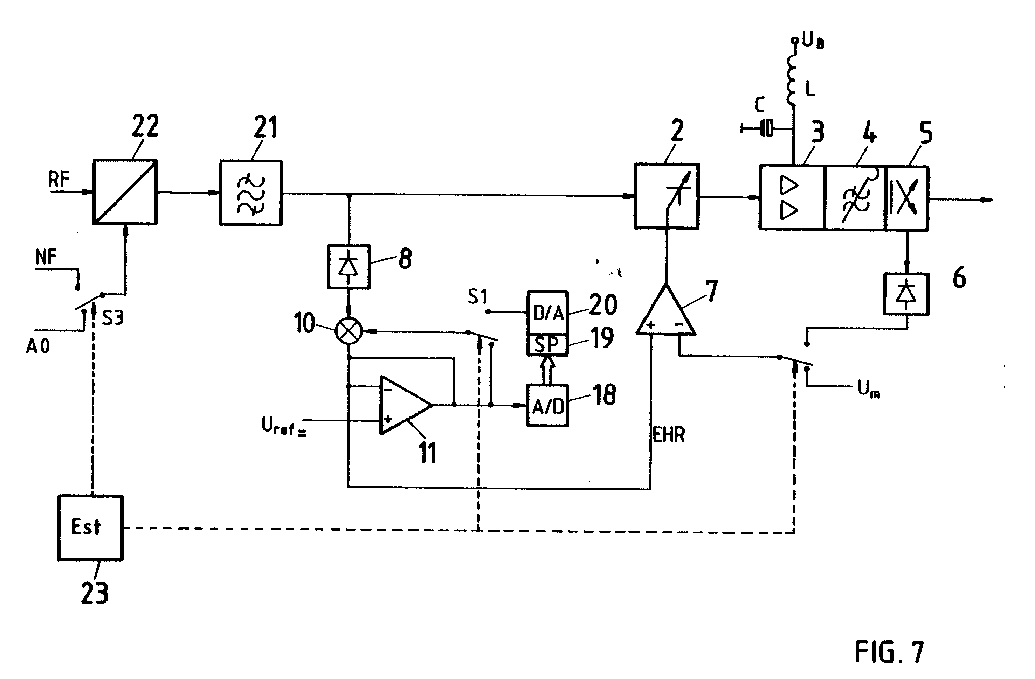

Wenn der Eingangspegel des zu übertragenden Nutzsignals zeitlich konstant ist und vor allem einen vorgegebenen Grenzwert nicht übersteigt, ist die in FIG. 7 skizzierte Schaltungsanordnung bevorzugt. Die Voraussetzung eines konstanten Signalpegels des Eingangssignals ist insbesondere bei der Übertragung digitaler Nachrichten erfüllt, da die das Eingangssignal für die Endstufe erzeugenden Geräteteile, wie z.B. ein Modulator von sich aus Signale mit langzeitlich konstantem Pegel generieren. Für die Pegelregelung sind dann im wesentlichen nur noch Pegelveränderungen zu berücksichtigen, die z.B. durch frequenzabhängige Amplitudenbeeinflussung in Eingangsbausteinen der Endstufe begründet sind und bei Frequenzumschaltungen störend in Erscheinung treten.

Die Einstellsteuerung 23 steuert die Schalter S1 bis S3 und schaltet dadurch, z.B. nach jedem Frequenzwechselkommando bei einem Frequenzsprungsender, zwischen einer Einstellphase und einer Sendephase um. Die eingezeichneten Schalterstellungen entsprechen der Einstellphase. Dadurch gelangt nach jedem Frequenzwechselkommando ein A0 (A null)-Signal für die Dauer von beispielsweise 1 ms über Sendeumsetzer 22 und Bandfilter 21 an den Einhüllenden-Detektor 8, wird im Multiplizierer 10 (analog) mit dem Spannungswert (Faktor) am Ausgang des Differenz-Operationsverstärkers 11 multipliziert. Der Einstellvorgang ist stabilisiert, wenn die Ausgangsspannung des Multiplizierers 10 der Referenz-Gleichspannung $U_{ref}$ entspricht. Dies ist bei entsprechender Dimensionierung des Operationsverstärkers 1 (Kap. Gegenkopplung C1) und des Multiplizierers 10 in weniger als 1 ms erreicht. Über den Schalter S2 ist an den invertierenden Eingang des Operationsverstärkers 7 eine mittlere Vergleichsspannung $U_m$ gelegt, die dafür sorgt, daß die Ausgangsleistung des Senderendverstärkers 3 während des Einstellvorgangs nicht über das erlaubte Maß hinausgeht. Über den A/D-Wandler ist der Multiplikationsfaktor in Speicher 19 abgelegt.

Für die nachfolgende Sendephase werden die Schalter S1 bis S3 umgeschaltet, so daß der Sendeumsetzer jetzt ein mit der zu übertragenden Nachricht NF-moduliertes Signal abgibt, das aber den gleichen Spitzenpegel aufweist wie das vorangegangene A0-Signal.

Der im Speicher 19 zuvor abgelegte digitalisierte Wert des Multiplikationsfactors wird während der Sendephase nicht verändert und über den D/A-Wandler 20 und S1 als konstanter Faktor dem Multiplizierer 10 zugeführt. Der A/D-Wandler 18 ist in der Sendephase ohne Wirkung, ebenso der Operationsverstärker 11.

Über Richtkoppler 5, Einhüllenden-Detektor 6 und Schalter S2 liegt nun die Einhüllendenspannung des Sendesignals am Differenzeingang des Operationsverstärkers 7, an dessen nicht invertiertem Eingang liegt die stabilisierte Referenz-Einhüllende des umgesetzten, im Rauschfilter von Oberwellen- und Außenband-Rauschen befreiten RF-Nutz-Signals.

Für die linearisierende Wirkung dieser Rückkopplungsschleife gelten die gleichen Ausführungen wie bei den bereits beschriebenen Anordnungen.

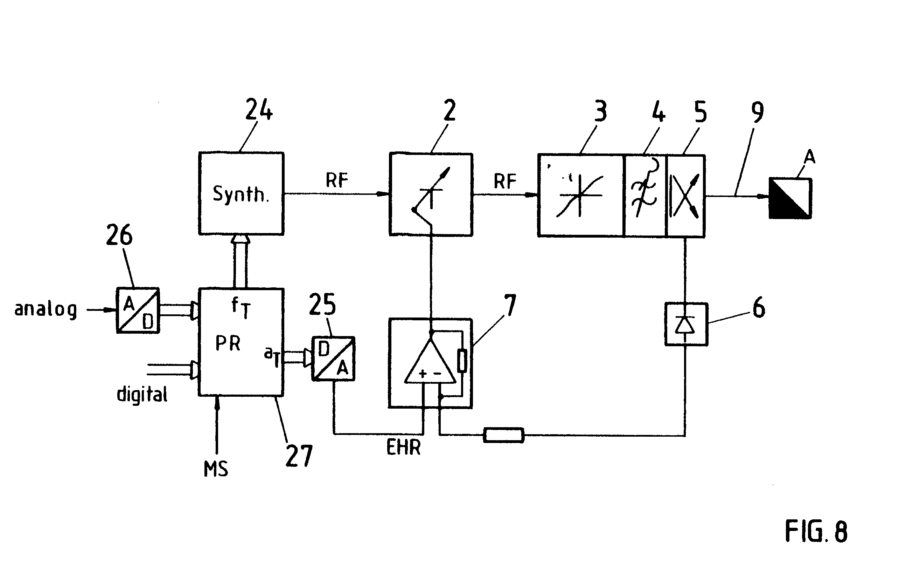

Die FIG. 8 zeigt eine bevorzugte Ausführung der Erfindung, die sich von den zuvor beschriebenen Ausführungen vor allem durch die besonders vorteilhafte Signalaufbereitung unterscheidet.

Der Prozessor PR weist einen Steuereingang MS auf, über den eine von mehreren Modulationsarten ausgewählt sowie weitere Signalparameter, wie Frequenz, Frequenzhub o.ä. vorgegeben werden. Das modulierende Signal kann entweder als digitales Signal (z.B. Tastfunk) direkt oder als analoges Signal (z.B. Sprache) über den Analog/Digital-Wandler 26 dem Signalprozessor zugeführt werden. Dieser erzeugt aus dem modulierenden Signal unter Brücksichtigung der gewählten Modulationsart ein Hüllkurven-Referenzsignal, das der Einhüllenden des Soll-Ausgangssignals der Endstufe proportional ist. Dieses Referenzsignal wird als Folge digitaler Werte $a_T$ dem Digital/Analog-Wandler 25 zugeführt, der an seinem Ausgang das analoge Hüllkurven-Referenzsignal EHR auf den nicht invertierenden Eingang des im Differenzglied 7 eingesetzten Operationsverstärkers leitet. Mittels des schnell einstellbaren Dämpfungsglieds 2 wird die Amplitude des vom Synthesizer 24 abgegebenen, nicht amplitudenmodulierten RF-Signals so beeinflußt, daß die Amplitude des Ausgangssssignals des Endverstärkers, die über den Richtkoppler 5 und den Hüllkurvendetektor 6 gemessen wird, ständig dem analogen Hüllkurven-Referenzsignal proportional ist. Der konstante Proportionalitätsfaktor ist durch die Beschaltung des Operationsverstärkers im Differenzglied 7 festgelegt. Von besonderem Vorteil ist, daß in dem Hüllkurven-Referenzsignal bereits die richtige Pegeleinstellung des Ausgangssignals auf die Nennleistung der Senderendstufe enthalten ist.

Der Signalprozessor gibt digitale Frequenzkommandos $f_T$ an den Synthesizer 24 ab und kann somit je nach Modulationsart (z. B. FM) oder bei Frequenzsprungsendungen schnell die Momentanfrequenz des RF-Signals variieren.

Die Pegelung der Ausgangsleistung wird bei dieser bevorzugten Anordnung allein durch das Referenz-Hüllkurvensignal des Signalprozessors bestimmt. Ein A0-Signal ist zur Pegelung auf die Nennleistung des Senders nicht erforderlich. Da das Hüllkurvensignal niederfrequent ist, ist die Geschwindigkeit gebräuchlicher Prozessoren vollkommen ausreichend. Der Prozessor ist vorzugsweise zur Erzeugung von Hüllkurvensignalen für verschiedene Modulationsarten ausgelegt. Die jeweils gewünschte Modulationsart ist über einen Steuereingang festlegbar. Der bei anderen Anordnungen gebräuchliche hochlineare Sendeumsetzer, bei welchem ein zwischenfrequentes Ausgangssignal mit einem stationären HF-Signal umgesetzt wird, entfällt, da die Amplitudenmodulation über das steuerbare Dämpfungsglied in der HF-Ebene erfolgt.

Beispielsweise ergibt sich für Sprachübertragung in Einseitenband-Modulation bei einem NF-Signal, das in Form einer Folge von Abtastwerten $F(k \cdot T)$ des Sprachsignals und dessen Hilberttransformierter $H(k \cdot T)$, mit $k \cdot T$ als Abtastzeitpunkte im Abstand T, vorliegt, für die Digitalwerte $a_T$ des Hüllkurven-Referenzsignals zum Zeitpunkt $k \cdot T$

$$a_T(k \cdot T) = \frac{1}{2} \sqrt{F^2(k \cdot T) + H^2(k \cdot T)} \quad .$$

Aus der Momentfrequenz des NF-Signals

$$f_{NF}(k \cdot T) = \frac{1}{T} \left\{ \arctan \frac{H((k+1) \cdot T)}{F((k+1) \cdot T)} - \arctan \frac{H(k \cdot T)}{F(k \cdot T)} \right\}$$

lassen sich bei gegebener Trägerfrequenz unmittelbar die HF-Frequenzsteuerwerte $f_T$ für das Einseitenbandsignal mit unterdrücktem Träger angeben.

Das Dämpfungsglied 2 kann vorteilhafterweise auch mehrere Dämpfungsstufen enthalten, von denen aber nur eine, vorzugsweise die letzte Stufe von dem Differenzglied angesteuert wird, während die anderen Stufen nicht an der Regelung beteiligt sind, sondern zur Voreinstellung beispielsweise bei gegenüber der Nennleistung des Senders reduziertem Signalpegel oder zur ungeregelten Amplitudenmodulation dienen können.

**Patentansprüche**

1. Senderanordnung mit einer transistorisierten Gegentakt-Endstufe (3) zur Leistungsverstärkung eines nach Maßgabe eines niederfrequenten Modulationssignals modulierten Hochfrequenzsignals, insbesondere für den KW-Bereich, wobei
   - im Zuge des Hochfrequenzsignals vor dem Eingang der Endstufe (3) ein steuerbares Dämpfungsglied (2) angeordnet ist,
   - an den Ausgang der Endstufe (3) ein Hüllkurvendetektor (6), der ein dem Sendesignal entsprechendes Hüllkurvensignal erzeugt, angekoppelt ist, und
   - in einem Differenzglied (7) aus dem Hüllkurvensignal und einem Referenzsignal ein Steuersignal für das Dämpfungsglied (2) erzeugt wird, derart, daß die von der Endstufe (3) erzeugten Amplitudenverzerrungen auf einen vernachlässigbaren Wert ausregelbar sind, dadurch gekennzeichnet,
   - daß ein steuerbarer frequenzvariabler Oszillator (24) zur Erzeugeung eines nicht amplitudenmodulierten Signals vorhanden ist, dessen Ausgangssignal an den Eingang des Dämpfungsglieds (2) gelegt ist,
   - daß das niederfrequente Modulationssignal einem digitalen Signalprozessor (27) zugeführt ist, der ein zeitveränderliches Frequenzsteuersignal für den steuerbaren Oszillator (24) und über einen D/A-Wandler (25) ein Einhüllenden-Referenzsignal für das Differenzglied (7) erzeugt,
   - daß verschiedene Modulationsarten vorgesehen sind und
   - daß der Signalprozessor (27) einen zusätzlichen Eingang (MS) zur Festlegung der Modulationsart aufweist.

2. Senderanordnung mit einer transistorisierten Gegenakt-Endstufe (3) zur Leistungsverstärkung eines nach Maßgabe eines niederfrequenten Modulationssignals modulierten Hochfrequenzsignals, insbesondere für den KW-Bereich, wobei
   - im Zuge des Hochfrequenzsignals vor dem Eingang der Endstufe (3) ein steuerbares Dämpfungsglied (2) angeordnet ist,
   - an den Ausgang der Endstufe (3) ein Hüllkurvendetektor (6), der ein dem Sendesignal entsprechendes Hüllkurvensignal erzeugt, angekoppelt ist, und
   - in einem Differenzglied (7) aus dem Hüllkurvensignal und einem Referenzssignal ein Steuersignal für das Dämpfungsglied (2) erzeugt wird, derart, daß die von der Endstufe (3) erzeugten Amplitudenverzerrungen auf einen vernachlässigbaren Wert ausregelbar sind, dadurch gekennzeichnet,
   - daß ein Sendeumsetzer (22) zur Erzeugung eines nicht amplitudenmoduliertes Signals an den Eingang des Dämpfungsgliedes (2) gekoppelt ist,
   - daß ein Einhüllenden-Referenzsignal mittels eines weiteren Hüllkurvendetektors (8) aus dem modulierten Hochfrequenzsignal vor dem Dämpfungsglied (2) gewonnen wird,
   - daß das Einhüllenden-Referenzsignal einem analog arbeitenden Multiplizierer (10) zugeführt wird,
   - daß der Ausgang des Multiplizierers (10) an einen Eingang eines Komparators (11), an dessen anderen Eingang eine Referenzgleichspannung ($U_{ref=}$) liegt, angeschlossen ist,
   - daß an dem Ausgang des Komparators (11) ein Korrektursignal als Gewichtsfaktor entsteht, das an einen weiteren Eingang des Multiplizierers (10) gelegt ist,
   - daß der Ausgang des Multiplizierers (10) zusätzlich an einen Eingang des Differenzgliedes (7) gelegt ist,
   - daß eine Einstellsteuerung (23) in einer Meßphase den Gewichtsfaktor digitalisiert und speichert und in einer nachfolgenden Übertragungsphase den Ausgang des Komparators (11), von dem Multiplizierer (10) trennt und den digital gespeicherten Gewichtsfaktor über eine Digital/Analog-Wandler (20) dem Multiplizierer (10) zuführt und
   - daß in der Meßphase ein unmoduliertes HF-Signal (AO) gleicher Frequenz und gleichen Pegels wie das Nachrichtensignal der nachfolgenden Übertragungsphase an den Eingang der Endstufe (3) gelegt ist.

3. Senderanordnung nach Ansprüchen 1 oder 2, dadurch gekennzeichnet, daß die Betriebsspannung der Endstufe (3) über ein L-C-Glied direkt aus einer ungeregelten Gleichspannung zugeführt ist.

**Claims**

1. Transmitter arrangement with a transistorised push-pull output stage (3) for power amplification of a high-frequency signal modulated in accordance with a low-frequency modulation signal, in particular for the short wave band, wherein
   - a controllable attenuating member (2) is arranged in the course of the high-frequency signal before the input of the output stage (3),
   - an envelope curve detector (6), which produces an envelope curve signal corresponding to the transmitted signal, is coupled to the output of the output stage (3)
   - a control signal for the attenuating member (2) is produced from the envelope curve signal and a reference signal in a difference member (7) in such a manner that the amplitude distortions produced by the output stage (3) are regulable out to a negligible value, characterised thereby,
   - that a controllable oscillator (24) of variable frequency is present for the production of a signal not modulated in amplitude, the output signal of which oscillator is applied to the input of the attenuating member (2),
   - that the low-frequency modulation signal is fed to a digital signal processor (27), which produces a frequency control signal of variable time for the controllable oscillator (24) and by way of a digital-to-analog converter (25) produces the envelope reference signal for the difference member (7),
   - that different kinds of modulation are provided and
   - that the signal processor (27) displays an additional input for fixing the kind of modulation.

2. Transmitter arrangement with a transistorised push-pull output stage (3) for power amplification of a high-frequency signal modulated in accordance with a low-frequency modulation signal, in particular for the short wave band, wherein
   - a controllable attenuating member (2) is arranged in the course of the high-frequency signal before the input of the output stage (3)
   - an envelope curve detector (6), which produces an envelope curve signal corresponding to the transmitter signal, is coupled to the output of the output stage (3)
   - a control signal for the attenuating member (2) is produced from the envelope curve signal and a reference signal in a difference member (7) in such a manner that the amplitude distortions produced by the output stage (3) are regulable out to a negligible value, characterised thereby, that a transmitting translator (22) for the production of a signal not modulated in amplitude is coupled to the input of the difference member (7),
   - that an envelope reference signal is obtained by means of a further envelope curve detector (8) from the modulated high-frequency signal before the attenuating member (2),
   - that the envelope reference signal is fed to a multiplier (10) operating in analog,
   - that the output of the multiplier (10) is connected to an input of a comparator (11), at the other input of which a reference direct voltage ($U_{ref=}$) is applied,
   - that a correction signal arises at the output of the comparator (11) as weighting factor and is applied to a further input of the multiplier (10),
   - that the output of the multiplier (10) is additionally applied to an input of the difference member (7),
   - that an adjusting control (23) in a measurement phase digitalises and stores the weighting factor and in a subsequent transmission phase separates the output of the comparator (11) from the multiplier (10) and feeds the digitally stored weighting factor by way of a digital-to-analog converter (20) to the multiplier (10) and
   - that an unmodulated high-frequency signal (AO) of the same frequency and the same level as the communications signal of the output stage (3) in the measurement phase.

3. Transmitter arrangement according to claim 1 or 2, characterised thereby, that the operating voltage of the output stage (3) is supplied by way of an L-C member directly from an unregulated direct voltage.

**Revendications**

1. Dispositif émetteur comportant un étage final symétrique (3) transistorisé pour l'amplification de puissance d'un signal haute fréquence modulé conformément à un signal de modulation basse fréquence, en particulier pour la classe de puissance de l'ordre d'un kW, dans lequel
   - un atténuateur (2) piloté est disposé dans le trajet du signal haute fréquence devant l'entrée de l'étage final (3),
   - un détecteur de courbe enveloppe (6), générant un signal de courbe enveloppe correspondant au signal d'émission, est couplé à la sortie de l'étage final (3) et
   - un signal pilote pour l'atténuateur (2) est produit dans un élément différenciateur (7) à partir du signal de courbe enveloppe et d'un signal de référence, de manière que les distorsions d'amplitude produites par l'étage final (3) puissent être réduites à une valeur négligeable par la régulation, caractérisé par le fait
   - qu'il comprend un oscillateur (24) piloté, à fréquence variable, pour générer un signal qui n'est pas modulé en amplitude, oscillateur dont le signal de sortie est appliqué à l'entrée de l'atténuateur (2),
   - que le signal de modulation basse fréquence est appliqué à un processeur de signal numérique (27) qui génère un signal de commande de fréquence variable dans le temps pour l'oscillateur (24) piloté et, à travers un convertisseur N/A (25) un signal de référence d'enveloppe pour l'élément différenciateur (7),
   - que plusieurs plusieurs modes de modulation sont prévus et
   - que le processeur de signal (27) présente une entrée supplémentaire (MS) pour fixer le mode de modulation.

2. Dispositif émetteur comportant un étage final symétrique (3) transistorisé pour l'amplification de puissance d'un signal haute fréquence modulé conformément à un signal de modulation basse fréquence, en particulier pour la classe de puissance de l'ordre d'un kW, dans lequel:
   - un atténuateur (2) piloté est disposé dans le trajet du signal haute fréquence devant l'entrée de l'étage final (3),
   - un détecteur de courbe enveloppe (6), générant un signal de courbe enveloppe correspondant au signal d'émission, est couplé à la sortie de l'étage final (3) et
   - un signal pilote pour l'atténuateur (2) est produit dans un élément différenciateur (7) à partir du signal de courbe enveloppe et d'un signal de référence, de manière que les distorsions d'amplitude produites par l'étage final (3) puissent être réduites à une valeur négligeable par la régulation, caractérisé par le fait
   - qu'un convertisseur d'émission (22) pour produire un signal non modulé en amplitude est couplé à l'entrée de l'atténuateur (2),
   - qu'un signal de référence d'enveloppe est obtenu au moyen d'un détecteur de courbe enveloppe supplémentaire (8) à partir du signal haute fréquence modulé avant l'atténuateur (2),
   - que le signal de référence d'enveloppe est appliqué à un multiplicateur (10) de type analogique,
   - que la sortie du multiplicateur (10) est connectée à une entrée d'un comparateur (11) dont l'autre entrée reçoit une tension continue de référence ($U_{ref=}$),
   - que la sortie du comparateur (11) fournit un signal de correction servant de facteur de pondération et qui est appliqué à une autre entrée du multiplicateur (10),
   - que la sortie du multiplicateur (10) est connectée en outre à une entrée de l'élement différenciateur (7),
   - qu'une commande de réglage (23) numérise et mémorise le facteur de pondération dans une phase de mesure et sépare la sortie du comparateur (11) du multiplicateur (10) et applique le facteur de pondération, mémorisé sous forme numérique, au multiplicateur (10) à travers un convertisseur numérique/analogique (20) dans une phase de transmission consécutive et
   - que, dans la phase de mesure, un signal HF non modulé (AO) de même fréquence et de même niveau que le signal d'information de la phase de transmission consécutive, est appliqué à l'entrée de l'étage final (3).

3. Dispositif émetteur selon la revendication 1 ou 2, caractérisé en ce que la tension de service de l'étage final (3) est appliquée directement, à travers un circuit L-C, à partir d'une tension continue non régulée.

FIG.1

FIG. 2

FIG. 3

FIG. 4

FIG. 5

FIG. 6

FIG. 7

FIG. 8